(19) Europäisches Patentamt / European Patent Office / Office européen des brevets

(11) **EP 4 299 517 A1**

(12) **EUROPEAN PATENT APPLICATION**
published in accordance with Art. 153(4) EPC

(43) Date of publication:
**03.01.2024  Bulletin 2024/01**

(21) Application number: **22759557.6**

(22) Date of filing: **21.02.2022**

(51) International Patent Classification (IPC):
$C01B\ 33/06^{(2006.01)}$          $C30B\ 25/06^{(2006.01)}$
$C30B\ 29/38^{(2006.01)}$          $C23C\ 14/06^{(2006.01)}$

(52) Cooperative Patent Classification (CPC):
**C01B 33/06; C23C 14/06; C30B 25/06; C30B 29/38**

(86) International application number:
**PCT/JP2022/006865**

(87) International publication number:
**WO 2022/181521 (01.09.2022 Gazette 2022/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 26.02.2021   JP 2021030789
26.02.2021   JP 2021030790
20.12.2021   JP 2021206432
20.12.2021   JP 2021206433

(71) Applicant: **Mitsubishi Materials Corporation
Tokyo 100-8117 (JP)**

(72) Inventors:
• **FUJITA Toshiaki
Naka-shi, Ibaraki 311-0102 (JP)**
• **ADACHI Masaki
Naka-shi, Ibaraki 311-0102 (JP)**

(74) Representative: **Hoffmann Eitle
Patent- und Rechtsanwälte PartmbB
Arabellastraße 30
81925 München (DE)**

(54) **NITRIDE SEMICONDUCTOR MATERIAL AND HEAT FLOW SWITCHING DEVICE COMPRISING SAME**

(57)   A nitride semiconductor material having low lattice thermal conductivity and a heat flow switching element including the same are provided. The nitride semiconductor material according to the present invention is a metal nitride represented by M-Si-N-Te (where M represents at least one kind of transition metal element, and Te represents an arbitrary element), and has a thermal effusivity of less than 2000 $Ws^{0.5}/m^2K$. In particular, the M is at least one of Cr, Mn, Ni, Mo, and W. In addition, a heat flow switching element according to the present invention includes an N-type semiconductor layer 3, an insulator layer 4 formed on the N-type semiconductor layer, and a P-type semiconductor layer 5 formed on the insulator layer, wherein at least one of the N-type semiconductor layer and the P-type semiconductor layer is formed from the nitride semiconductor material described above.

[FIG. 1]

EP 4 299 517 A1

**Description**

Technical Field

The present invention relates to a nitride semiconductor material having low lattice thermal conductivity and a heat flow switching element including the same.

Background Art

Conventionally, as a heat flow switch that actively changes thermal conductivity by a bias voltage, for example, Non Patent Literature 1 has proposed a heat flow switching element that changes thermal conductivity by sandwiching a polyimide tape exhibiting electrical insulation between two semiconductor materials: $Ag_2S_{0.6}Se_{0.4}$ and applying an electric field.

Citation List

Non Patent Literature

Non Patent Literature 1: Takuya Matsunaga and four other persons, "Preparation of heat Flow Switching Element Operating By Bias Voltage", the 15th Academic Lecture of Thermoelectrics Society of Japan, September 13, 2018

Summary of Invention

Technical Problem

The conventional technique described above still has the following problems.
In the technique described in Non Patent Literature 1, since by applying a voltage, a thermally conductive charge can be generated at an interface between a semiconductor material and an insulator material and heat can be carried by the charge, it is possible to immediately transition to a state in which thermal conduction has changed, and relatively good thermal responsiveness can be obtained. However, in order to change the thermal conduction caused at the material interface according to this external electric field (external voltage) and increase the amount of change in the thermal conduction of the entire element, it is necessary to reduce the thermal conductivity inherent to the material constituting the element at zero bias (state where no external voltage is applied). The thermal conductivity is a function proportional to the square of the thermal effusivity, and it is necessary to reduce the thermal effusivity inherent to the material constituting the element at zero bias. The thermal conductivity inherent to the material at zero bias is expressed by the sum (addition) of the lattice thermal conductivity and the electronic thermal conductivity.

$$\texttt{thermal conductivity = lattice thermal conductivity +}$$

$$\texttt{electronic thermal conductivity}$$

The lattice thermal conduction is thermal conduction by vibration (phonon, lattice vibration) transmitted between crystal lattices. In addition, electronic thermal conduction is thermal conduction by conduction electrons, and generally, when the electrical conductivity increases, the electronic thermal conductivity tends to increase. Among these, regarding the electronic thermal conductivity of semiconductor, in order to maintain the electrical conductivity of the semiconductor, it is necessary to adjust the electronic thermal conductivity inherent to the material at the time of zero bias to an appropriate value to such an extent that the total thermal conduction is not large. To be noted, an insulator material does not have electron thermal conduction. Meanwhile, the lattice thermal conductivity is preferably as small as possible. When the material has a low lattice thermal conductivity, the thermal conductivity of the entire element at zero bias can be reduced, so that the rate of change in the thermal conductivity originating from the interface according to the external electric field can be increased, and the heat flow switching performance of the entire element can be improved. Therefore, it is desired to use a semiconductor material having low thermal conductivity (low thermal effusivity) derived from low lattice thermal conductivity and an insulator material. In addition, in order to improve the heat resistance of a heat flow switching element, it is desired to use a nitride material as a constituent material.
The present invention has been made in view of the above-described problems, and an object thereof is to provide a nitride semiconductor material having low lattice thermal conductivity and a heat flow switching element including the same.

Solution to Problem

In order to solve the above problems, the present invention adopts the following configuration. That is, a nitride semiconductor material according to a first invention is characterized by being a metal nitride represented by M-Si-N-Te (where M represents at least one kind of transition metal element, and Te represents an arbitrary element), and having a thermal effusivity of less than 2000 $Ws^{0.5}/m^2K$.

This nitride semiconductor material is a metal nitride represented by M-Si-N-Te (where M represents at least one kind of transition metal element, and Te represents an arbitrary element), has a thermal effusivity of less than 2000 $Ws^{0.5}/m^2K$, therefore has P-type or N-type semiconductor characteristics, and has low lattice thermal conductivity, so that low thermal conductivity indicating low thermal effusivity can be obtained. Note that since the M element among the constituent elements being at least one kind of transition metal element improves electrical conductivity, and Si (silicon) nanocrystalizes (a crystal size of 5 nm or less, including amorphous matter) the crystal structure and can reduce the lattice thermal conductivity, the thermal effusivity can be reduced.

To be noted, the notation "Te is an arbitrary element" indicates whether or not to contain Te (tellurium) is arbitrary. That is, it is indicated that Te may or may not be included. In other words, it is M-Si-N or M-Si-N-Te (where M represents at least one kind of transition metal element).

A nitride semiconductor material according to a second invention is characterized in that, in the first invention, the metal nitride is represented by M-Si-N (where M represents at least one kind of transition metal element).

A nitride semiconductor material according to a third invention is characterized in that, in the first or second invention, the electrical resistivity is less than 10 Qcm.

That is, since this nitride semiconductor material is a nitride including a transition metal element and is a compound having a transition metal-nitrogen bond, which is likely to have electrical conductivity, an electrical resistivity of less than 10 Qcm is obtained, and the nitride semiconductor material is suitable as a semiconductor material having excellent electrical conductivity.

A nitride semiconductor material according to a fourth invention is characterized by being a nanocrystal in any one of the first to third inventions.

This nitride semiconductor material is a metal nitride represented by M-Si-N-Te (where M represents at least one kind of transition metal element, and Te represents an arbitrary element), and is a nanocrystal, therefore has P-type or N-type semiconductor characteristics, and has low lattice thermal conductivity, so that low thermal conductivity indicating low thermal effusivity can be obtained. Note that since the M among the constituent elements being at least one kind of transition metal element improves electrical conductivity, and Si nanocrystalizes (a crystal size of 5 nm or less, including amorphous matter) the crystal structure and can reduce the lattice thermal conductivity, the thermal effusivity can be reduced.

A nitride semiconductor material according to a fifth invention is characterized in that, in any one of the first to fourth inventions, the M is at least one of Cr, Mn, Ni, Mo, and W.

That is, in this nitride semiconductor material, since the M described is at least one of Cr, Mn, Ni, Mo, and W, a metal nitride material having a low thermal effusivity and a low electrical resistivity can be obtained.

A nitride semiconductor material according to a sixth invention is characterized by being used as a low thermal conduction material in any one of the first to fifth inventions.

That is, this nitride semiconductor material has a low thermal effusivity, and is therefore suitable for a low thermal conductivity semiconductor material used for a heat flow switching element or the like.

A heat flow switching element according to a seventh embodiment is characterized by including an N-type semiconductor layer, an insulator layer formed on the N-type semiconductor layer, and a P-type semiconductor layer formed on the insulator layer, wherein at least one of the N-type semiconductor layer and the P-type semiconductor layer is formed from the nitride semiconductor material according to any one of the first to sixth inventions.

That is, since this heat flow switching element includes the N-type semiconductor layer, the insulator layer formed on the N-type semiconductor layer, and the P-type semiconductor layer formed on the insulator layer, when an external voltage is applied to the N-type semiconductor layer and the P-type semiconductor layer, a charge is induced mainly at the interfaces of the insulator layer with the P-type semiconductor layer and the N-type semiconductor layer, and the thermal conductivity changes as the charge carries heat.

In particular, since at least one of the N-type semiconductor layer and the P-type semiconductor layer is formed from the nitride semiconductor material according to any one of the first to sixth inventions, low thermal effusivity can be obtained, and the rate of change in thermal conductivity can be changed greatly by an external electric field (external voltage).

In addition, in a case where the insulator layer is a nitride, at least one of the N-type semiconductor layer and the P-type semiconductor layer is a nitride, and thus, the bondability of the interface between the semiconductor layer and the insulator layer is enhanced.

The increase rate Δk of the thermal conductivity after voltage application, which is heat flow switching performance, is evaluated by the following equations.

$$\Delta k = k(V)/k(0) - 1$$

$$\Delta k = b(V)^2/b(0)^2 - 1$$

k(V): thermal conductivity (W/mK) with voltage application
k(0): thermal conductivity (W/mK) without voltage application
b(V): thermal effusivity (Ws$^{0.5}$/m$^2$K) with voltage application
b(0): thermal effusivity (Ws$^{0.5}$/m$^2$K) without voltage application

The thermal conductivity originating from the interface, which is changed by the external voltage, is defined as a "third thermal conductivity", and is distinguished from the thermal conductivity (addition of the lattice thermal conductivity and the electronic thermal conductivity) inherent to the material, which is not changed by the external voltage, for the sake of convenience.

```
    k(V) = electronic thermal conductivity of semiconductor
+ lattice thermal conductivity of semiconductor + lattice
thermal conductivity of insulator + third thermal
conductivity
    k(0) = electronic thermal conductivity of semiconductor
+ lattice thermal conductivity of semiconductor + lattice
thermal conductivity of insulator
```

Therefore, in order to improve the heat flow switching performance, it is preferable to select a material having small electronic thermal conductivity and lattice thermal conductivity. Among these, regarding the electronic thermal conduction of semiconductor, in order to maintain the electrical conductivity of the semiconductor, it is necessary to adjust the electronic thermal conductivity inherent to the material at the time of zero bias to an appropriate value to such an extent that the total thermal conduction is not large. In contrast, regarding the lattice thermal conductivity, in the case of a material having a low lattice thermal conductivity, since k(0) can be reduced and the thermal conductivity of the entire element at zero bias can be reduced, when the lattice thermal conductivity is lower, the contribution of the third thermal conductivity to the thermal conductivity in response to the external electric field from the zero bias is greater, and the rate of change in the thermal conductivity according to the external electric field is larger, so that the heat flow switching performance is improved.

To be noted, since the charge is generated at both the interface between the N-type semiconductor layer and the insulator layer and the vicinity thereof and the interface between the P-type semiconductor layer and the insulator layer and the vicinity thereof, so that the amount of generated charge is large, and a large change in thermal conductivity and a high thermal responsiveness can be obtained. In addition, since the mechanism physically changes the thermal conductivity without using a chemical reaction mechanism, it is possible to immediately transition to a state in which thermal conduction has changed, and to obtain good thermal responsiveness.

In addition, since the amount of charge induced at the interface changes by multiplication of the magnitude of the external voltage, the thermal conductivity can be adjusted by adjusting the external voltage, so that the heat flow can be actively controlled via the present device.

Note that since the insulator layer is an insulator and no current is generated due to voltage application, Joule heat is not generated. Therefore, the heat flow can be actively controlled without self-heating.

Advantageous Effects of Invention

According to the present invention, the following effects are achieved.

That is, according to the nitride semiconductor material of the present invention, it is a metal nitride represented by M-Si-N-Te (where M represents at least one kind of transition metal element, and Te represents an arbitrary element), has a thermal effusivity of less than 2000 $Ws^{0.5}/m^2K$, therefore has P-type or N-type semiconductor characteristics, and has low lattice thermal conductivity, so that low thermal conductivity indicating low thermal effusivity can be obtained.

As described above, the nitride semiconductor material of the present invention has a low thermal effusivity, and is therefore suitable for a low thermal conductivity semiconductor material used for a heat flow switching element or the like.

Therefore, in the heat flow switching element of the present invention, since at least one of the N-type semiconductor layer and the P-type semiconductor layer is formed from the nitride semiconductor material of the present invention described above, the rate of change in thermal conductivity according to the external electric field is increased by the N-type semiconductor layer or the P-type semiconductor layer having low lattice thermal conductivity, and the heat flow switching performance is improved.

Brief Description of Drawings

Fig. 1 is a perspective view illustrating one embodiment of a nitride semiconductor material according to the present invention and a heat flow switching element including the same.

Fig. 2 is a conceptual diagram for describing a principle in the present embodiment.

Fig. 3 are cross-sectional SEM images showing Comparative Examples of the nitride semiconductor material according to the present invention and the heat flow switching element including the same.

Fig. 4 are cross-sectional SEM images showing Examples of the nitride semiconductor material according to the present invention and the heat flow switching element including the same.

Fig. 5 are cross-sectional TEM images showing Examples of the nitride semiconductor material according to the present invention and the heat flow switching element including the same.

Fig. 6 is a cross-sectional TEM image showing an Example of the nitride semiconductor material according to the present invention and the heat flow switching element including the same.

Description of Embodiments

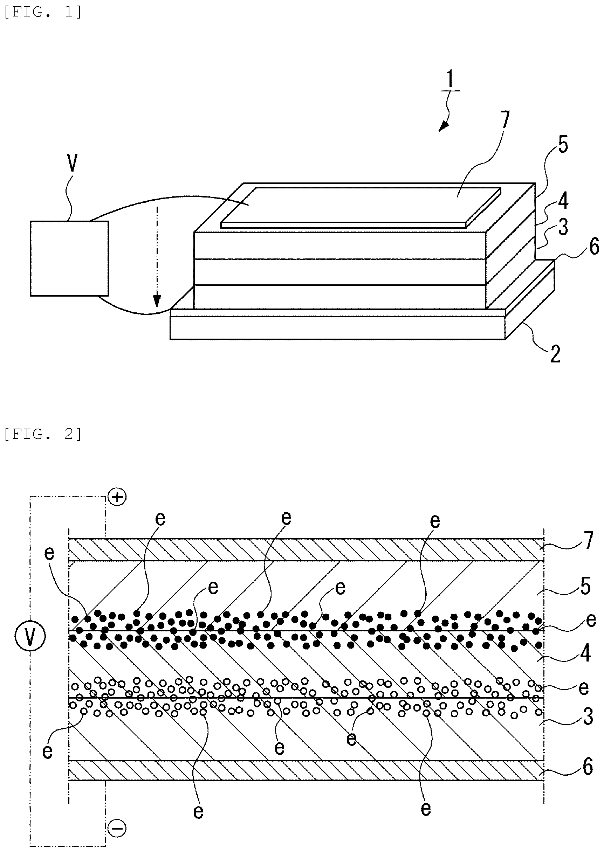

Hereinafter, one embodiment of a nitride semiconductor material and a heat flow switching element including the same according to the present invention will be described with reference to Figs. 1 and 2. Note that, in the drawings used in the following description, the scale is appropriately changed as necessary in order to make each part recognizable or easily recognizable.

As illustrated in Figs. 1 and 2, a heat flow switching element 1 of the present embodiment includes an N-type semiconductor layer 3, an insulator layer 4 formed on the N-type semiconductor layer 3, and a P-type semiconductor layer 5 formed on the insulator layer 4.

Furthermore, the heat flow switching element 1 of the present embodiment includes an N-side electrode 6 connected to the N-type semiconductor layer 3 and a P-side electrode 7 connected to the P-type semiconductor layer 5.

The N-type semiconductor layer 3 and the P-type semiconductor layer 5 described above are a nitride semiconductor material of a low thermal conduction material, are a metal nitride represented by M-Si-N-Te (to be noted, M represents at least one kind of transition metal element, and Te represents an arbitrary element), and have a thermal effusivity of less than 2000 $Ws^{0.5}/m^2K$ and an electrical resistivity of less than 10 Ωcm.

In addition, the nitride semiconductor material described above is a nanocrystal.

To be noted, in the present specification, a crystal having a crystal size of 5 nm or less is referred to as a nanocrystal, including a case of an amorphous matter.

In addition, the crystal size is determined by randomly selecting crystals of 10 points in a cross-sectional TEM image and calculating the average value of their equivalent circle diameters.

The M described above is at least one of Cr, Mn, Ni, Mo, and W.

That is, the metal nitride described above is Cr-Si-N, Mn-Si-N, Ni-Si-N, Mo-Si-N, W-Si-N, Cr-W-Si-N, Cr-Si-N-Te, W-Si-N-Te, or the like.

As film forming methods of these, various film forming methods such as a sputtering method and a molecular beam epitaxy method (MBE method) are adopted.

With regard to the sputtering method, a film of the metal nitride described above can be formed by using targets of various composition ratios in a sputtering apparatus while changing the sputtering gas pressure, the nitrogen gas partial pressure, and the like under a mixed gas atmosphere of Ar gas + nitrogen gas.

To be noted, a small amount of O (oxygen) may be contained as an inevitable impurity during film formation.

In addition, when a voltage can be directly applied to the N-type semiconductor layer 3 and the P-type semiconductor layer 5, the N-side electrode 6 and the P-side electrode 7 are unnecessary.

In addition, the heat flow switching element 1 of the present embodiment includes an insulating substrate 2, and an N-side electrode 6 is formed on the substrate 2. That is, the N-side electrode 6, the N-type semiconductor layer 3, the insulator layer 4, the P-type semiconductor layer 5, and the P-side electrode 7 are laminated in this order on the substrate 2. Note that the layers may be laminated on the substrate 2 in the order opposite to the above order. In addition, the substrate 2 itself may be used as the P-side electrode 7 or the N-side electrode 6.

An external power supply V is connected to the N-side electrode 6 and the P-side electrode 7, and a voltage is applied thereto. To be noted, an arrow in Fig. 1 indicates an application direction of a voltage (electric field).

The N-type semiconductor layer 3 and the P-type semiconductor layer 5 are formed as thin films having a thickness of less than 1 um. In particular, since charge e (positive charge, negative charge) generated at the interface with the insulator layer 4 and in the vicinity thereof is mainly accumulated in a thickness range of 5 to 10 nm, the N-type semiconductor layer 3 and the P-type semiconductor layer 5 are more preferably formed to have a film thickness of 100 nm or less. To be noted, the N-type semiconductor layer 3 and the P-type semiconductor layer 5 preferably have a film thickness of 5 nm or more.

In addition, the film thickness of the insulator layer 4 is preferably 40 nm or more, and is set to a thickness that does not cause dielectric breakdown. Note that, if the insulator layer 4 is too thick, it becomes difficult to carry the charge e, and thus, the insulator layer 4 preferably has a film thickness of less than 1 $\mu$m.

To be noted, in Fig. 2, the type of the charge e generated at the interface between the N-type semiconductor layer 3 and the insulator layer 4 and in the vicinity thereof is electrons, and is indicated by white circles. In addition, the type of the charge e generated at the interface between the P-type semiconductor layer 5 and the insulator layer 4 and in the vicinity thereof is holes, and is indicated by black circles. (Holes are holes formed by a shortage of electrons in the valence band of the semiconductor, and relatively appear to have a positive charge.)

The N-type and P-type of the N-type semiconductor layer 3 and the P-type semiconductor layer 5 are set by the selection of the M element, the composition ratio Si/(M + Si) ratio, and the content of N (nitrogen). Note that the N-type and P-type can also be set by adding metal elements exhibiting the N-type and P-type as dopants to the nitride semiconductor material described above.

The insulator layer 4 is preferably an insulating material having a low thermal conductivity, and an insulator such as $SiO_2$, a dielectric such as $HfO_2$ or $BiFeO_3$, an organic material such as polyimide (PI), or the like can be adopted. In particular, a dielectric material having a high dielectric constant is preferable.

As the substrate 2 described above, for example, a glass substrate or the like can be adopted.

The N-side electrode 6 described above and the P-side electrode 7 described above are made of metal such as Mo or Al, for example.

As illustrated in Fig. 2, in the heat flow switching element 1 of the present embodiment, the charge e capable of conducting heat are generated at the interface between the N-type semiconductor layer 3 and the insulator layer 4 and the vicinity thereof by application of an electric field (voltage), so that the generated charge e carries heat and the thermal conductivity changes.

In order to obtain a larger change in the thermal conductivity by the charge generated at the interface and the vicinity thereof by application of an electric field (voltage), a material having a small lattice thermal conductivity is suitable, and the nitride semiconductor material described above of the present embodiment is a material having a small lattice thermal conductivity, that is, a small thermal conductivity.

In addition, the third thermal conductivity defined above increases according to the amount of the charge e generated according to the applied external electric field (voltage).

To be noted, since the charge e is generated at the interface between the N-type semiconductor layer 3 and the P-type semiconductor layer 5 and the insulator layer 4, the amount of the generated charge e can also be increased by increasing the total area of the interface.

The method of measuring the thermal conductivity described above is performed by, for example, a pulsed light heating thermoreflectance method, which is a method of instantaneously heating a thin film sample formed on a substrate with a pulse laser, measuring a decrease rate of surface temperature deriving from thermal diffusion into the thin film or an increase rate of the surface temperature, and thus obtaining the thermal diffusivity or the thermal effusivity of the thin film in the film thickness direction. Among the above-described pulsed light heating thermoreflectance methods, a method of directly measuring thermal diffusion (rear surface heating/ front surface temperature measurement (RF) method) requires use of a transparent substrate through which a pulse laser can pass, and therefore, when the substrate is not a transparent substrate, the thermal conductivity is measured by a front surface heating/temperature measurement (FF) method which is a method of measuring and converting the thermal effusivity into the thermal conductivity. Note that a metal film is required for this measurement, and Mo, Al, or the like is adopted.

In the present embodiment, the thermal effusivity is measured by a front surface heating/temperature measurement (FF) method.

In the heat flow switching element 1 of the present embodiment, the charge e is generated at both the interface between the N-type semiconductor layer 3 and the insulator layer 4 and the vicinity thereof and the interface between the P-type semiconductor layer 5 and the insulator layer 4 and the vicinity thereof, so that the amount of generated charge is large, and a large change in thermal conductivity and a high thermal responsiveness can be obtained. In addition, since the mechanism physically changes the thermal conductivity without using a chemical reaction mechanism, it is possible to immediately transition to a state in which thermal conduction has changed, and to obtain good thermal responsiveness.

In addition, since the amount of charge induced at the interface changes by multiplication of the magnitude of the external voltage, the thermal conductivity can be adjusted by adjusting the external voltage, so that the heat flow can be actively controlled via the present device.

Note that since the insulator layer 4 is an insulator and no current is generated due to voltage application, Joule heat is not generated. Therefore, the heat flow can be actively controlled without self-heating.

In addition, in a case where the insulator layer is a nitride, at least one of the N-type semiconductor layer and the P-type semiconductor layer is a nitride, and thus, the bondability of the interface between the semiconductor layer and the insulator layer is enhanced.

As described above, since the nitride semiconductor material (the N-type semiconductor layer 3 and the P-type semiconductor layer 5) of the present embodiment is a metal nitride represented by M-Si-N-Te (to be noted, M represents at least one kind of transition metal element, and Te represents an arbitrary element) and has a thermal effusivity of less than 2000 $Ws^{0.5}/m^2K$, the nitride semiconductor material has P-type or N-type semiconductor characteristics and has low lattice thermal conductivity, so that low thermal conductivity indicating low thermal effusivity can be obtained. To be noted, M among the constituent elements being at least one kind of transition metal element improves the electrical conductivity, and Si nanocrystalizes (crystal size of 5 nm or less, including amorphous matter) the crystal structure and reduces the thermal effusivity.

In addition, since the nitride semiconductor material of the present embodiment is a nitride including a transition metal element and is a compound having a transition metal-nitrogen bond, which is likely to have electrical conductivity, an electrical resistivity of less than 10 Qcm is obtained, and the nitride semiconductor material is suitable as a semiconductor material having excellent electrical conductivity.

Furthermore, since M described above is at least one of Cr, Mn, Ni, Mo, and W, a metal nitride material having a low thermal effusivity and a low electrical resistivity can be obtained.

Since the heat flow switching element 1 of the present embodiment includes the N-type semiconductor layer 3, the insulator layer 4 formed on the N-type semiconductor layer 3, and the P-type semiconductor layer 5 formed on the insulator layer 4, when an external voltage is applied to the N-type semiconductor layer 3 and the P-type semiconductor layer 5, the charge e is induced mainly at the interfaces of the insulator layer 4 with the P-type semiconductor layer 5 and the N-type semiconductor layer 3, and the thermal conductivity changes as the charge e carries heat.

In particular, since the N-type semiconductor layer 3 and the P-type semiconductor layer 5 are formed from the nitride semiconductor material described above, low thermal conductivity having low lattice thermal conductivity and indicating low thermal effusivity can be obtained at the time of zero bias, and the rate of change in thermal conductivity can be increased by an external electric field (external voltage). That is, when the lattice thermal conductivity is lower, the contribution of the thermal conductivity originating from the interface in response to the external electric field from zero bias becomes greater, and the rate of change of the thermal conductivity according to the external electric field becomes greater, thereby improving the heat flow switching performance.

Examples

For Examples of the present invention in which a film of a material (Cr-Si-N, Mn-Si-N, Ni-Si-N, Mo-Si-N, W-Si-N, Cr-W-Si-N, Cr-Si-N-Te, and W-Si-N-Te) described in the following Tables 1 and 2 was formed on $SiO_2$ by reactive sputtering in a nitrogen-containing atmosphere on the basis of the above embodiment, the crystal structure, the thermal effusivity, and the electrical resistivity were measured. The results are shown in Tables 1 and 2.

To be noted, the composition of each Example was set by changing the nitrogen fraction ($N_2/(Ar + N_2)$ ratio) and also changing the Si/(M + Si) ratio.

In the composition analysis, elemental analysis was performed by X-ray photoelectron spectroscopy (XPS). In XPS, quantitative analysis was performed on a sputtered surface having a depth of 20 nm from the outermost surface by Ar sputtering. To be noted, regarding the quantitative accuracy, the quantitative accuracy of the N/(M + Si + N) ratio was ± 2%, and the quantitative accuracy of the Si/(M + Si) ratio was ± 1%.

The electrical resistivity (specific resistance) was measured at 25°C by a four-terminal method (van der pauw method). The determination regarding the N-type and P-type of the semiconductor was made by Hall effect measurement. The magnitude of the applied magnetic field at the time of Hall effect measurement was set to 0.5 tesla.

In addition, also for cases where a film having a columnar crystal structure (Cr-N, Cr-Si-N, Mn-N, Mo-N, W-N) as a crystal structure was formed, the results of measuring the thermal effusivity and the electrical resistivity thereof are also shown in Table 1 as Comparative Examples.

The thermal effusivity described above was measured by the FF method (front surface heating/front surface temperature measurement) of the pulsed light heating thermoreflectance method (measurement apparatus: PicoTR manufactured by PicoTherm Corporation). The measurement was performed at room temperature.

The thermal conductivity is calculated from the thermal effusivity by the following formula.

```
thermal conductivity k = (thermal effusivity b)²/volume

heat capacity

   = (thermal effusivity b)²/(specific heat × density)
```

[Table 1]

| | Composition | Crystal structure | M element | M (at%) | Si (at%) | N (at%) | Si/(M + Si) ratio (at%) | Thermal effusivity (Ws$^{0.5}$/m$^2$K) | Electrical resistivity (Ωcm) | P-type or N-type |
|---|---|---|---|---|---|---|---|---|---|---|
| Comparative Example1 | CrN | Columnar crystal | Cr | 63.0 | 0.0 | 37.0 | 0.0 | 3129 | 2.01E-02 | N |
| Comparative Example2 | CrN | Columnar crystal | Cr | 61.2 | 0.0 | 38.8 | 0.0 | 3089 | 1.18E-02 | P |
| Comparative Example3 | CrSiN | Columnar crystal | Cr | 42.3 | 6.6 | 51.1 | 13.4 | 2668 | 1.44E-02 | N |
| Comparative Example4 | CrSiN | Columnar crystal | Cr | 40.7 | 7.9 | 51.4 | 16.3 | 2846 | 6.56E-02 | P |
| Comparative Example5 | MnN | Columnar crystal | Mn | 58.0 | 0.0 | 42.0 | 0.0 | 4519 | 1.42E-03 | N |
| Comparative Example6 | MoN | Columnar crystal | Mo | 64.0 | 0.0 | 36.0 | 0.0 | 3392 | 4.01E-04 | N |
| Comparative Example7 | WN | Columnar crystal | W | 82.3 | 0.0 | 17.7 | 0.0 | 3256 | 4.52E-04 | N |
| Comparative Example8 | WN | Columnar crystal | W | 78.7 | 0.0 | 21.3 | 0.0 | 3495 | 7.67E-04 | N |
| Example1 | CrSiN | Nanocrystal | Cr | 30.4 | 29.7 | 39.8 | 49.4 | 1982 | 3.71E-02 | N |
| Example2 | CrSiN | Nanocrystal | Cr | 27.7 | 25.9 | 46.4 | 48.4 | 1817 | 2.10E-01 | N |
| Example3 | CrSiN | Nanocrystal | Cr | 27.5 | 26.1 | 46.5 | 48.7 | 1830 | 1.66E-01 | P |
| Example4 | MnSiN | Nanocrystal | Mn | 29.8 | 25.0 | 45.1 | 45.6 | 1851 | 1.11E-01 | P |
| Example5 | MnSiN | Nanocrystal | Mn | 32.2 | 22.3 | 45.5 | 40.9 | 1641 | 4.16E-01 | P |
| Example6 | NiSiN | Nanocrystal | Ni | 38.1 | 28.7 | 33.2 | 43.0 | 1904 | 6.18E-03 | N |
| Example7 | NiSiN | Nanocrystal | Ni | 43.3 | 28.3 | 28.4 | 39.6 | 1829 | 9.07E-03 | N |
| Example8 | MoSiN | Nanocrystal | Mo | 42.9 | 33.7 | 23.4 | 44.0 | 1905 | 4.04E-03 | P |
| Example9 | MoSiN | Nanocrystal | Mo | 41.8 | 31.0 | 27.3 | 42.6 | 1662 | 2.02E-02 | P |
| Example10 | WSiN | Nanocrystal | W | 40.9 | 21.7 | 37.4 | 34.7 | 1786 | 1.69E-02 | P |
| Example11 | WSiN | Nanocrystal | W | 36.2 | 21.5 | 42.3 | 37.3 | 1563 | 6.52E-02 | P |
| Example12 | WSiN | Nanocrystal | W | 35.4 | 18.5 | 46.1 | 34.4 | 1424 | 5.67E-01 | P |
| Example14 | WSiN | Nanocrystal | W | 43.9 | 14.5 | 41.6 | 24.8 | 1816 | 3.42E-03 | P |
| Example15 | WSiN | Nanocrystal | W | 40.8 | 16.8 | 42.3 | 29.2 | 1613 | 8.93E-02 | P |
| Example16 | WSiN | Nanocrystal | W | 37.2 | 24.7 | 38.0 | 39.9 | 1970 | 1.31E-02 | P |
| Example17 | WSiN | Nanocrystal | W | 34.8 | 25.9 | 39.3 | 42.7 | 1760 | 4.12E-02 | P |
| Example18 | WSiN | Nanocrystal | W | 30.7 | 22.5 | 46.8 | 42.3 | 1633 | 8.93E-01 | P |

| | Composition | Crystal structure | M element | Cr (at%) | W (at%) | Si (at%) | N (at%) | Si/(M + Si) ratio (at%) | Electrical resistivity (Ωcm) | Thermal effusivity (Ws$^{0.5}$/m$^2$K) | P-type or N-type |
|---|---|---|---|---|---|---|---|---|---|---|---|
| Example13 | CrWSiN | Nanocrystal | Cr,W | 16.9 | 22.5 | 16.0 | 44.6 | 28.8 | 6.027E-03 | 1583 | P |

[Table 2]

| | Composition | Crystal structure | M element | M (at%) | Si (at%) | N (at%) | Te (at%) | Si/(M + Si) ratio (at%) | Electrical resistivity (Ωcm) | Thermal effusivity (Ws$^{0.5}$/m$^2$K) | P-type or N-type |
|---|---|---|---|---|---|---|---|---|---|---|---|
| Example21 | CrSiNTe | Nanocrystal | Cr | 32.3 | 28.8 | 9.4 | 29.6 | 47.1 | 6.2E+00 | 865 | P |
| Example22 | WSiNTe | Nanocrystal | W | 45.8 | 22.0 | 31.9 | 0.3 | 32.5 | 5.7E-03 | 1885 | P |
| Example23 | WSiNTe | Nanocrystal | W | 35.5 | 20.1 | 44.3 | 0.1 | 36.1 | 7.5E-03 | 1512 | P |
| Example24 | WSiNTe | Nanocrystal | W | 57.7 | 10.8 | 22.5 | 9.0 | 15.7 | 1.2E+00 | 949 | P |
| Example25 | WSiNTe | Nanocrystal | W | 62.8 | 15.7 | 9.5 | 12.0 | 20.0 | 4.2E+00 | 784 | P |
| Example26 | WSiNTe | Nanocrystal | W | 63.1 | 10.8 | 7.8 | 18.3 | 14.6 | 6.0E-01 | 533 | P |

From these results, whereas the crystal structure was a columnar crystal and the thermal permeability was 2500 Ws$^{0.5}$/m$^2$K or more in each Comparative Example, each Example of the present invention was a low thermal conduction material having nanocrystal as the crystal structure and a low thermal permeability of less than 2000 Ws$^{0.5}$/m$^2$K. In addition, the electrical resistivity of each Example of the present invention was less than 10 Ωcm.

In particular, in Examples 1 to 13, the electrical resistivity was less than 1 Qcm.

In addition, Examples 21 and 24 to 26 containing Te by 9 at% or more were low thermal conduction materials having a thermal effusivity of less than 1000 $Ws^{0.5}/m^2K$.

In addition, Examples 21 to 26 containing Te were P-type semiconductors.

In addition, as Example 27 of the present invention, a material (Ni-Si-N-Te) in which Te was added to the N-type semiconductor of Ni-Si-N of Example 6 was also prepared.

To be noted, the thermal effusivity of Example 27 (Ni-Si-N-Te) in which the Te amount was less than 9 at% was 1163 $Ws^{0.5}/m^2K$, and the thermal effusivity was much smaller than that of Ni-Si-N of Example 6. In addition, the electrical resistivity of this Example 27 (Ni-Si-N-Te) was $9.46 \times 10^{-3}$ Qcm, and was an N-type semiconductor.

To be noted, regarding the composition range of each element of M-Si-N-Te in Examples 1 to 27, M was 27.5 to 63.1 at%, Si was 10.8 to 33.7 at%, N was 7.8 to 46.8 at%, Te was 0 to 29.6 at%, and the total of the elements was 100 at%. In addition, Si/(M + Si) was 14.6 to 49.4 at%.

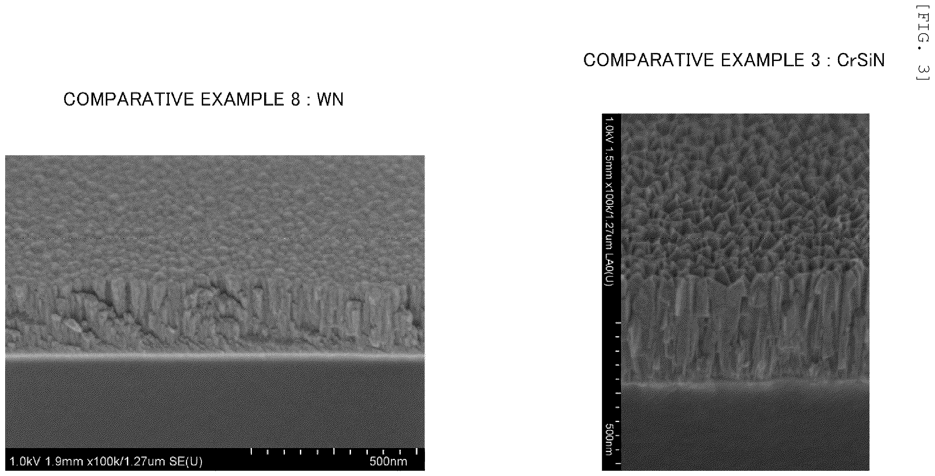

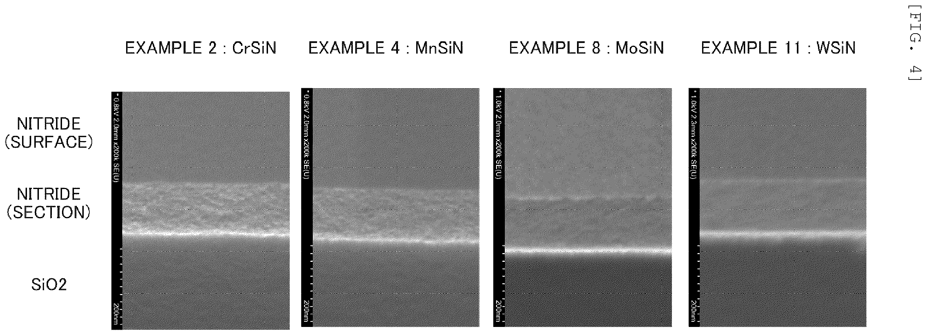

Next, cross-sectional SEM images (field of view of an oblique angle of 45 degrees) of some of Comparative Examples and Examples are shown in Figs. 3 and 4. Fig. 3 shows both the cross-sectional structures and the surface structures of the Cr-Si-N film of Comparative Example 3 and the W-N film of Comparative Example 8. Fig. 4 shows both the cross-sectional structures and the surface structures of the Cr-Si-N film of Example 2, the Mn-Si-N film of Example 4, the Mo-Si-N film of Example 8, and the W-Si-N film of Example 11. A substrate obtained by cleavage fracture was used, and for example, breakage of columnar crystals or the like occurred when the substrate was cleaved and fractured.

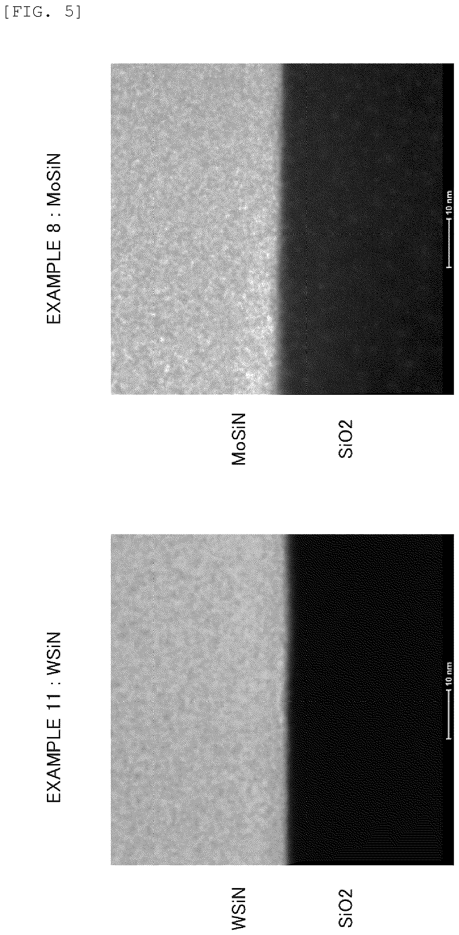

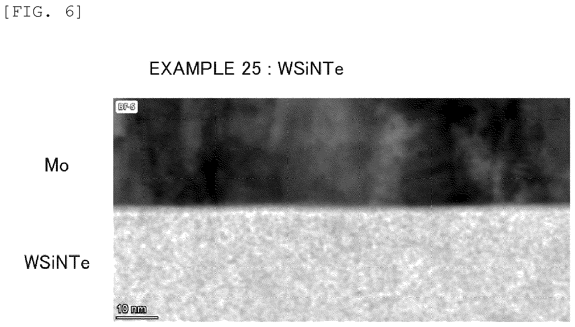

Further, cross-sectional TEM: HAADF-STEM (High-Angle Annular Dark Field Scanning Transmission Electron Microscopy) images of some of the Comparative Examples and Examples are shown in Figs. 5 and 6. Fig. 5 shows cross-sectional structures of the Mo-Si-N film of Example 8 and the W-Si-N film of Example 11. Fig. 6 shows the cross-sectional structure of the W-Si-N-Te film of Example 25.

As can be seen from these images, the crystal structures of the Comparative Examples are columnar crystal structures having a diameter of 10 to 20 nm, whereas the crystal structures of the Examples of the present invention are dense nanocrystal structures having a crystal size of 5 nm or less. Furthermore, for Examples in which cross-sectional TEM observation was performed, electron beam diffraction of the film cross section was performed, and no electron beam diffraction image showing long-period crystallinity, which suggested that the crystal size was relatively large, was detected, and it was confirmed that the film had a nanocrystal structure with a very small crystal size. To be noted, in the present specification, a crystal having a crystal size of 5 nm or less is referred to as a nanocrystal, including a case of an amorphous matter.

Grazing incidence X-ray diffraction (thin film XRD) was also performed, and a peak indicating a crystalline film was observed for the columnar crystal materials of the Comparative Examples, but no peak indicating long-period crystallinity, which suggests a relatively large crystal size, was detected for the Examples, and this indicates a nanocrystal film having a very small crystal size. (In the present specification, a crystal having a crystal size of 5 nm or less is referred to as a nanocrystal, including a case of an amorphous matter.)

Furthermore, it can be seen that the nanocrystal films of the Examples have high surface smoothness, high fineness, and high density. That is, the low thermal conduction does not originate from a small density originating from voids or the like, and indicates that the present nitride material itself has a low thermal conductivity. These results indicate that nanocrystallization reduced thermal conduction by vibration (phonon, lattice vibration) transmitted between crystal lattices, reduced lattice thermal conduction, and thus a low thermal conductivity semiconductor material having a thermal effusivity of less than 2000 $Ws^{0.5}/m^2K$ was obtained.

Next, heat flow switching elements including the nitride semiconductor materials of the above Examples of the present invention as P-type semiconductor layers were produced, and the results of measuring the thermal effusivity with respect to voltage and measuring the increase rate of the thermal conductivity after voltage application are shown in Table 3.

To be noted, an insulator layer, a P-type semiconductor layer, and a P-side electrode were laminated on an N-type semiconductor layer using the following materials to form an Example of the present invention, and change in the thermal conductivity thereof was measured.

N-type semiconductor layer: Si substrate of N-type semiconductor (thickness: 0.38 mm)
Insulator layer: $SiO_2$ (thickness: 100 nm)
P-type semiconductor layer:

CrSiN (Example 3)
WSiN (Example 11)
WSiNTe (Example 25)
(thickness: each 40 nm)

P-side electrode: Mo (thickness: 100 nm)

To be noted, it had been confirmed that each of the SiO$_2$ (thickness: 100 nm) and the P-type semiconductor layer (thickness: 40 nm) was had a thermal conductivity of less than 2 W/mK in the form of a single film.

An Au line was connected to the Si substrate of the N-type semiconductor and Mo of the P-side electrode, and a voltage was applied. In addition, the measurement was performed at room temperature.

[Table 3]

| | Element structure | Voltage (V) | Thermal effusivity (Ws$^{0.5}$/m$^2$K) | Increase rate of thermal conductivity after voltage application(%) |
|---|---|---|---|---|
| Example 3 | Mo 100nm / CrSiN 40nm / SiO2 100nm /Si substrate 0.38mm | 0 | 1573 | 0.0% |
| | | 10 | 1621 | 6.2% |
| Example 11 | Mo 100nm / WSiN 40nm / SiO2 100nm /Si substrate 0.38mm | 0 | 1453 | 0.0% |
| | | 3 | 1460 | 1.0% |
| | | 5 | 1486 | 4.6% |
| | | 10 | 1491 | 5.3% |
| | | 30 | 1496 | 6.0% |
| Example 25 | Mo 100nm / WSiNTe 50nm / SiO2 100nm /Si substrate 0.38mm | 0 | 765 | 0.0% |
| | | 5 | 774 | 2.6% |
| | | 10 | 786 | 5.7% |
| | | 15 | 803 | 10.3% |
| | | 40 | 837 | 20.0% |
| | | 50 | 856 | 25.4% |

To be noted, the thermal effusivity was measured by the FF method (front surface heating/front surface temperature measurement) of the pulsed light heating thermoreflectance method (measurement apparatus: PicoTR manufactured by PicoTherm Corporation). The measurement was performed at room temperature.

The thermal conductivity is calculated from the thermal effusivity by the following formula.

```
thermal conductivity k = (thermal effusivity b)²/volume

heat capacity

            = (thermal effusivity b)²/(specific heat × density)
```

Therefore, the increase rate Δk of the thermal conductivity after voltage application is evaluated by the following equations.

```
Δk = k(V)/k(0) - 1
```

```
Δk = b(V)²/b(0)² - 1
```

k(V): thermal conductivity (W/mK) with voltage application
k(0): thermal conductivity (W/mK) without voltage application
b(V): thermal effusivity ($Ws^{0.5}/m^2K$) with voltage application
b(0): thermal effusivity ($Ws^{0.5}/m^2K$) without voltage application

In the measurement by the pulsed light heating thermoreflectance method (FF method) described above, the element is instantaneously heated with a pulse laser from the Mo film side of the P-side electrode, and the decrease rate of the surface temperature due to heat diffusion into the thin film is measured to measure the thermal effusivity of the thin film.

When the thermal effusivity is large, that is, when the thermal conductivity is large, the heat transfer becomes greater, and the time for the temperature to decrease becomes shorter.

As can be seen from these results, in each of the Examples of the present invention, the thermal effusivity at zero bias (a state in which no external voltage is applied) is less than 2000 $Ws^{0.5}/m^2K$, and the increase rate of the thermal conductivity after voltage application increases in accordance with an increase in voltage.

In particular, in the heat flow switching element including the nitride semiconductor material of Example 25 containing Te as the P-type semiconductor layer, the thermal effusivity at zero bias is smaller, and the increase rate of the thermal conductivity after voltage application is further increased in accordance with the increase in voltage.

The thermal effusivity of the nitride semiconductor material as a single material containing Te in an amount of 9 at% or more shows a low thermal effusivity of less than 1000 $Ws^{0.5}/m^2K$, and it can be considered that, in Example 25, since the thermal effusivity b(0) of the heat flow switching element at zero bias could be reduced by using an extremely low thermal conduction material, the rate of change in thermal conductivity originating from the interface according to the external electric field could be increased, the increase rate Δk of the thermal conductivity after voltage application was increased, and thus the heat flow switching performance could be improved.

Note that the technical scope of the present invention is not limited to the above-described embodiments and Examples, and various modifications can be made without departing from the gist of the present invention.

For example, in the nitride semiconductor material of the present invention described above, M described above is at least one kind of transition metal element, but if a large amount of Ta or Hf is included, insulating properties are enhanced and semiconductor characteristics cannot be obtained, and thus Ta and Hf are not preferable as elements of main components constituting M. To be noted, when at least one transition metal element such as Cr, Mn, Ni, Mo, or W described above as M is used as a main component element, at least one of Ta and Hf may be contained in a trace amount as long as semiconductor characteristics can be obtained.

Reference Signs List

1    heat flow switching element

3 N-type semiconductor layer
4 insulator layer
5 P-type semiconductor layer

**Claims**

1. A nitride semiconductor material that is a metal nitride represented by M-Si-N-Te (where M represents at least one kind of transition metal element, and Te represents an arbitrary element), and has a thermal effusivity of less than 2000 Ws$^{0.5}$/m$^2$K.

2. The nitride semiconductor material according to claim 1, wherein the metal nitride is represented by M-Si-N (where M represents at least one kind of transition metal element).

3. The nitride semiconductor material according to claim 1 having an electrical resistivity of less than 10 Qcm.

4. The nitride semiconductor material according to claim 1 that is a nanocrystal.

5. The nitride semiconductor material according to claim 1, wherein the M is at least one of Cr, Mn, Ni, Mo, and W.

6. The nitride semiconductor material according to claim 1 that is used as a low thermal conduction material.

7. A heat flow switching element comprising:

an N-type semiconductor layer;
an insulator layer formed on the N-type semiconductor layer; and
a P-type semiconductor layer formed on the insulator layer,
wherein at least one of the N-type semiconductor layer and the P-type semiconductor layer is formed from the nitride semiconductor material according to claim 1.

[FIG. 1]

[FIG. 2]

[FIG. 3]

COMPARATIVE EXAMPLE 3 : CrSiN

1.0kV 1.5mm x100k/1.27um LA0(U)　　　500nm

COMPARATIVE EXAMPLE 8 : WN

1.0kV 1.9mm x100k/1.27um SE(U)　　　500nm

[FIG. 4]

[FIG. 5]

EP 4 299 517 A1

EXAMPLE 11 : WSiN

EXAMPLE 8 : MoSiN

WSiN

SiO2

MoSiN

SiO2

[FIG. 6]

EXAMPLE 25 : WSiNTe

Mo

WSiNTe

<p style="text-align:center;">**INTERNATIONAL SEARCH REPORT**</p>

| International application No. |
|---|
| **PCT/JP2022/006865** |

**A.  CLASSIFICATION OF SUBJECT MATTER**

    *C01B 33/06*(2006.01)i; *C30B 25/06*(2006.01)i; *C30B 29/38*(2006.01)i; *C23C 14/06*(2006.01)i
    FI:   C01B33/06; C30B25/06; C30B29/38 B; C23C14/06 A; C23C14/06 E

According to International Patent Classification (IPC) or to both national classification and IPC

**B.  FIELDS SEARCHED**

Minimum documentation searched (classification system followed by classification symbols)

    C01B33/06; C30B25/06; C30B29/38; C23C14/06

Documentation searched other than minimum documentation to the extent that such documents are included in the fields searched

    Published examined utility model applications of Japan 1922-1996
    Published unexamined utility model applications of Japan 1971-2022
    Registered utility model specifications of Japan 1996-2022
    Published registered utility model applications of Japan 1994-2022

Electronic data base consulted during the international search (name of data base and, where practicable, search terms used)

    JSTPlus (JDreamIII); JST7580 (JDreamIII); JSTChina (JDreamIII)

**C.  DOCUMENTS CONSIDERED TO BE RELEVANT**

| Category* | Citation of document, with indication, where appropriate, of the relevant passages | Relevant to claim No. |
|---|---|---|
| X | WO 2016/153073 A1 (MITSUBISHI MATERIALS CORP) 29 September 2016 (2016-09-29) | 1–3, 5–6 |
| | claim 1, paragraphs [0014], [0056]-[0057], table 1 | |
| Y | | 7 |
| A | | 4 |
| Y | 松永卓也他, バイアス電圧で制御する熱流スイッチング素子の創製, 日本熱電学会誌, 2019, vol. 16, no.2, pp. 73-76 | 7 |
| | in particular, 2. Operating principle of heat flow switching device, (MATSUNAGA, Takuya et al. A field effect heat flow switching device. The Journal of the Thermoelectrics Society of Japan.) | |
| X | JP 2019-129188 A (MITSUBISHI MATERIALS CORP) 01 August 2019 (2019-08-01) | 1–5 |
| | claim 1, table 1 | |
| A | | 6-7 |
| X | JP 2017-174974 A (MITSUBISHI MATERIALS CORP) 28 September 2017 (2017-09-28) | 1-3, 5 |
| | claim 1, table 1 | |
| A | | 4, 6-7 |

☐ Further documents are listed in the continuation of Box C.   ☑ See patent family annex.

\*   Special categories of cited documents:
"A"  document defining the general state of the art which is not considered to be of particular relevance
"E"  earlier application or patent but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search | Date of mailing of the international search report |
|---|---|
| **31 March 2022** | **12 April 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/006865**

| Patent document cited in search report | | | Publication date (day/month/year) | Patent family member(s) | Publication date (day/month/year) |
|---|---|---|---|---|---|
| WO | 2016/153073 | A1 | 29 September 2016 | JP 2016-184636 A claim 1, paragraphs [0014], [0056]-[0057], table 1 | |
| JP | 2019-129188 | A | 01 August 2019 | (Family: none) | |
| JP | 2017-174974 | A | 28 September 2017 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TAKUYA MATSUNAGA.** Preparation of heat Flow Switching Element Operating By Bias Voltage. *15th Academic Lecture of Thermoelectrics Society of Japan,* 13 September 2018